# EUROPEAN PATENT SPECIFICATION

(11) **EP 3 624 186 B1**
(45) Date of publication and mention of the grant of the patent: **03.11.2021**
(21) Application number: 19190002.6
(22) Date of filing: 05.08.2019
(51) Int. Cl.: H01L 23/552, H01L 23/66, H01L 23/49

(54) **ELECTROMAGNETICALLY-SHIELDED MICROELECTRONIC ASSEMBLIES**
ELEKTROMAGNETISCH ABGESCHIRMTE MIKROELEKTRONISCHE ANORDNUNGEN
ENSEMBLES MICROÉLECTRONIQUES À BLINDAGE ÉLECTROMAGNÉTIQUE

(30) Priority: 21.08.2018 US 201816107089
(43) Date of publication of application: 18.03.2020
(73) Proprietor: NXP USA, Inc., Austin TX 78735 (US)
(72) Inventor: SRINDHI EMBAR, Ramanujam, 5656 AG Eindhoven (NL); SHILIMKAR, Vikas, 5656 AG Eindhoven (NL); VISWANATHAN, Lakshminarayan, 5656 AG Eindhoven (NL)
(74) Representative: Lee, Candice Jane

(56) References cited:
- EP-A1- 1 631 137
- EP-A2- 2 892 076
- US-A1- 2016 380 606

## Description

### TECHNICAL FIELD

The present invention relates generally to microelectronics and, more particularly, to microelectronic assemblies containing enhanced electromagnetic shield structures.

### ABBREVIATIONS

The following abbreviations appear throughout this document:
Cu-copper;
EM-electromagnetic or electromagnetically;
Fe-iron;
GaN-gallium nitride;
MIMO-multiple input, multiple output (antenna structure);
PA-power amplification;
RF-radio frequency; and
µᵣ-relative (magnetic) permeability.

### BACKGROUND

EM cross-coupling (more informally, "cross-talk") can occur between separate signal paths in microelectronic assemblies including microelectronic packages, modules, and systems. EM cross-coupling may be particularly problematic in the context of small-scale, high power RF applications. Consider, for example, an RF PA assembly containing high gain transistor die integrated into a package or module having a relatively compact form factor. By common design, the RF PA assembly may include with two or more transistor die attached to a base flange in a side-by-side relationship. Bondwire arrays may electrically interconnect the transistor die with other circuit elements, such as the PA terminals, integrated passive capacitors, or other devices contained in the RF PA assembly. Due to the close proximity of the transistor die and their corresponding bondwire arrays, EM cross-coupling may occur and, if sufficiently severe, may limit the performance of the microelectronic assembly; e.g., EM cross-coupling may displace the impedances presented to the transistor die, which, in turn, may detract from RF performance in terms of linearity, efficiency, peak power, or gain.

There thus exists an ongoing demand for the provision of microelectronic assemblies (e.g., packages, modules, and systems) less susceptible to EM cross-coupling, including when having a relatively compact form factor and operated at higher RF frequencies or power levels. Ideally, embodiments of such microelectronic assemblies would provide enhanced shielding of adjacent signal paths from both magnetic and electrical aspects of EM cross-coupling, while maintaining high level assembly performance and remaining cost effective to manufacture. Similarly, it is desirable to provide methods for manufacturing microelectronic assemblies having such favorable characteristics. Other desirable features and characteristics of embodiments of the present disclosure will become apparent from the subsequent Detailed Description and the appended Claims, taken in conjunction with the accompanying drawings and the foregoing Background.

US 2016/380606 A1 describes a vertical magnetic barrier for an integrated electronic module. More particularly, US2016/380606 A1 discloses an electromagnetically-shielded microelectronic assembly, comprising:
a first signal path and a second signal path, which carry different electrical signals during operation of the microelectronic assembly; and an electromagnetic (EM) shield structure positioned between the first and
second signal paths, the EM shield structure comprising:
   a magnetic shield portion having a first magnetic permeability and a first electrical conductivity; and
   an electrical shield portion adjacent the magnetic shield portion, the electrical shield portion having a second magnetic permeability less than the first magnetic permeability and having a second electrical conductivity greater than the first electrical conductivity.

EP 2892076 A2 describes a semiconductor package having an isolation wall to reduce electromagnetic coupling.

EP 1631137 A1 describes a module component provided with an electrical shield and a method of manufacture.

### SUMMARY

According to the invention, there is provided an electromagnetically-shielded microelectronic assembly according to claim 1.

### BRIEF DESCRIPTION OF THE DRAWINGS

Embodiments of the present invention are depicted in figures 6-8. Other examples of the present disclosure will hereinafter be described in conjunction with figures 2-5 and 9-12, wherein like numerals denote like elements, and:
FIG. 1 is a diagram illustrating a core magnetic component of EM cross-coupling between adjacent signal paths in a microelectronic assembly (partially shown) containing an electrical shield structure, as depicted in accordance with the teachings of prior art;
FIG. 2 is a diagram of an example microelectronic assembly (partially shown) containing an enhanced EM shield structure, which minimizes EM cross-coupling between separate or distinct signal paths;
FIG. 3 is a schematic of a microelectronic assembly (here, an RF PA package) containing one or more EM shield structures;
FIG. 4 is an isometric view of two adjacent interconnect features (here, neighboring bondwire arrays) separated by an intervening EM shield structure, which includes continuous, non-patterned electrical and magnetic shield layers;
FIG. 5 graphically depicts simulated improvements in gain, cross-coupling, and isolation achieved by the EM-shielded microelectronic assembly shown in FIG. 4, as compared to similar microelectronic assemblies containing an electrical shield structure and lacking any shield structure;
FIGs. 6 and 7 are isometric views of adjacent bondwire arrays separated by an intervening EM shield structure, which includes patterned magnetic shield layer (FIG. 6) and a patterned electrical shield layer (FIG. 7) bonded to opposing surfaces of a shield substrate, such as a core dielectric layer, as illustrated in accordance with an exemplary embodiment of the claimed invention;
FIG. 8 illustrates a magnetic flux concentration plot modeled in a plane between the adjacent bondwire arrays shown in FIGs. 6-7 and suitable for usage in determining the shape, disposition, and/or thickness distribution of the patterned magnetic shield layer shown in FIG. 6;
FIG. 9 is an isometric view of adjacent bondwire arrays separated by an intervening EM shield structure in the form of a coated wire fence, as illustrated in accordance with an exemplary implementation of the present disclosure;
FIG. 10 is a cross-sectional view taken through the coated wire fence shown in FIG. 9 more clearly illustrating an electrically-conductive wire core and magnetically-permeable coating within the wire fence;
FIG. 11 is an isometric view of adjacent bondwire arrays separated by an intervening EM shield structure, which includes lateral extensions or wings covering microelectronic devices (e.g., integrated capacitors) over which the bondwire arrays extend; and
FIG. 12 is a top-down view of a microelectronic assembly and, specifically, a massive MIMO system including multiple EM shield structures, which may have construction similar or identical to that described in any of FIGs. 4, 6, 7, and 11.

For simplicity and clarity of illustration, descriptions and details of well-known features and techniques may be omitted to avoid unnecessarily obscuring the examples not forming part of the claimed invention and the non-limiting embodiments of the invention described in the subsequent Detailed Description. It should further be understood that features or elements appearing in the accompanying figures are not necessarily drawn to scale unless otherwise stated. For example, the dimensions of certain elements or regions in the figures may be exaggerated relative to other elements or regions to improve understanding of embodiments of the invention.

### DETAILED DESCRIPTION

The following Detailed Description is merely exemplary in nature and is not intended to restrict the scope of the invention, as set-out in the claim, in any respect.

### DEFINITIONS

The following definitions apply throughout this document. Those terms not expressly defined here or elsewhere in this document are assigned their ordinary meaning in the relevant technical field.

**Electrically-conductive material-**A material having an electrical resistivity less than 1 milli-Ohm millimeter at 20 degrees Celsius (°C).

**Electromagnetically-shielded microelectronic assembly-**a microelectronic assembly (defined below) including at least one electromagnetic (EM) shield structure reducing magnetic and electrical cross-coupling between signal paths during operation of the assembly.

**Interconnect Feature-**An electrical conductor or a group of electrical conductors electrically connecting two or more points-of-contact, such as terminals or bond pads, contained in a microelectronic assembly.

**Magnetically-permeable material-**A material having a relative magnetic permeability (µᵣ) exceeding 1000.

**Microelectronic assembly-**a generic term utilized to broadly encompass microelectronic packages, modules, systems, and other articles of manufacture containing microelectronic circuitry.

**Mu metal-**any alloy composed principally of nickel (Ni) and Fe, by weight, and having a relative magnetic permeability exceeding 1000.

**Relative magnetic permeability** (µᵣ)-the ratio of magnetic permeability of a material or medium (µ) over the magnetic permeability of free space (µ₀).

**Supermalloy-**an alloy predominately composed of Ni, Fe, and molybdenum (Mo), by weight, and having a relative magnetic permeability exceeding 1000.

### OVERVIEW

As discussed above, the performance of microelectronic packages, modules, systems, and other microelectronic assemblies can be limited by EM cross-coupling in certain instances. EM cross-coupling occurs due to interference between the EM fields generated when signal-containing electrical currents are directed through different or separate signal paths contained within an EM assembly. EM cross-coupling may be particularly problematic in certain applications, such as when the signal paths come into close proximity (e.g., due to a relative compact form factor of the assembly) and the assembly is operated at higher RF frequencies and/or power levels. Microelectronic assemblies containing high frequency RF circuitry, such as RF PA packages and modules, are often particularly susceptible to EM cross-coupling.

To date, industry efforts have focused on addressing the electrical component of EM cross-coupling, largely to the exclusion of addressing the magnetic component of EM cross-coupling. Accordingly, conventional electrical shield structures often assume the form of monolithic or single-layer walls composed of materials having relatively high electrical conductivities and low magnetic permeabilities, such as Cu. While potentially reducing electrical cross-coupling, such conventional electrical shield structures have little impact on the magnetic component of EM cross-coupling and, thus, provide an incomplete solution to the wholesale reduction or prevention of EM cross-coupling. Concurrently, conventional electrical shield structures may detract from other aspects of microelectronic assembly performance. For example, the provision of such electrical shield structures often entails the insertion of a relatively large body of electrically conductive material within the induced EM fields, which may result in eddy current losses, hysteresis effects, exacerbation of RF mismatch (when applicable), and other issues.

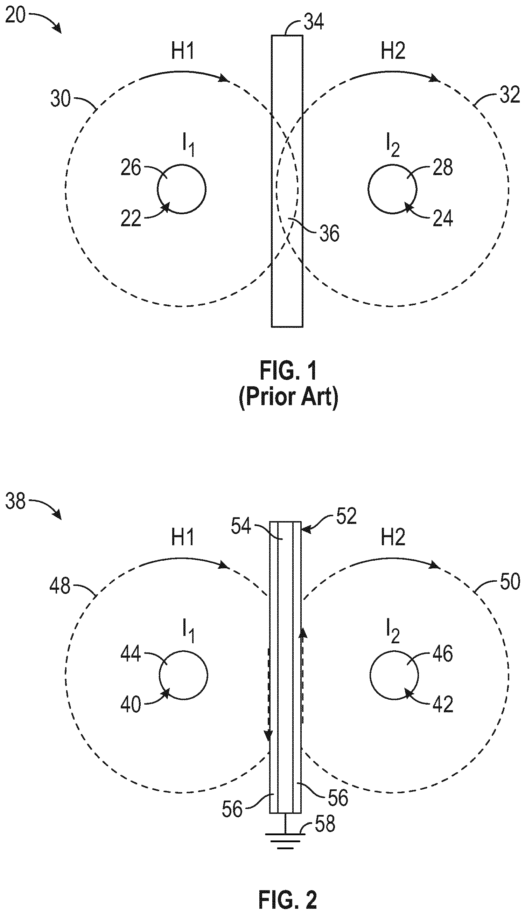

Further emphasizing the concept outlined above, FIG. 1 diagrammatically illustrates a limited portion of a conventional electrically-shielded microelectronic assembly **20.** The depicted portion of microelectronic assembly **20** includes two signal paths **22, 24,** which project into and out of the plane of the page. Signal paths **22, 24** are formed in part by (and, therefore, extend through) interconnects or bondwires **26, 28,** respectively, as shown in cross-section in FIG. 1. Bondwires **26, 28** extend alongside one another in relatively close proximity for some distance. When signal-carrying currents (I₁, I₂) are directed along signal paths **22, 24** and, thus, conducted through bondwires **26, 28,** corresponding magnetic fields are generated around bondwires **26, 28** in vectors normal to the electrical currents. The respective cores of the magnetic fields are labeled in FIG. 1 as "Hi" and "H₂," while the outer boundaries of the core magnetic fields are represented by dashed circles **30, 32.** It will be appreciated that the induced magnetic fields may extend well-beyond dashed circles **30, 32** such that the magnetic field induced by passing current through bondwire **26** may impinge upon adjacent bondwire **28** and the magnetic field induced by passing current through bondwire **28** may impinge upon adjacent bondwire **26,** potentially resulting in EM interference or cross-coupling as described below.

Signal paths **22, 24** carry separate or distinct electrical signals during operation of microelectronic assembly **20.** The signals carried by signal paths **22, 24** may be digital signals, analog signals, or a combination thereof. Regardless of the signal type or types at issue, EM cross-coupling can potentially occur between signal paths **22, 24** due to the relative close proximity of bondwires **26, 28,** depending upon the operational parameters of assembly **20;** e.g., as noted above, EM cross-coupling may be particularly problematic in high frequency (e.g., RF) applications. In accordance with conventional approaches directed toward reducing the electrical aspects of EM cross-coupling, an intervening electrical shield structure **34** (hereafter, "electrical shield **34")** may be positioned between bondwires **26, 28.** When provided, electrical shield **34** may assume the form of a monolithic or single-layer wall, which is composed of a material (e.g., Cu) having a relatively high electrical conductivity and a relatively low magnetic permeability. While potentially reducing electrical cross-coupling between signal paths **22, 24,** electrical shield **34** does little to reduce magnetic cross-coupling between the core magnetic fields (Hi, H₂). Instead, due to the low magnetic permeability of electrical shield **34,** the core magnetic fields (Hi, H₂) may freely pass through the body of shield **34** and comingle or overlap in interference zone **36,** as illustrated. When one (or both) of the core magnetic fields (Hi, H₂) induced by passing current through a first of signal paths **22, 24** becomes sufficiently wide or expansive to impinge upon the other of signal paths **22, 24,** this impingement may alter the signal characteristics resulting in EM cross-coupling. Stated differently, the EM field induced by passing an electrical signal through one of signal paths **22, 24** may cause EM interference due direct to impingement of that EM field overlapping on fields caused by passing another electrical signal through the other of signal paths **22, 24,** and vice versa. Excessive magnetic cross-coupling and, more broadly, EM cross-coupling may consequently occur thereby limiting the performance of assembly **20** in the previously-described manner.

Turning to FIG. 2, a diagram of a limited portion of an EM-shielded microelectronic assembly **38** is illustrated in accordance with an exemplary embodiment of the present disclosure. In a general sense, EM-shielded microelectronic assembly **38** is similar to electrically-shielded microelectronic assembly **20** shown in FIG. 1. Once again, EM-shielded microelectronic assembly **38** includes two signal paths **40, 42,** which carry different or distinct electrical signals during operation of assembly **38.** Signal paths **40, 42** extend through interconnect features **44, 46,** which project into and out of the page. As shown in cross-section in FIG. 2, interconnect features **44,46** can be bondwires, metal (e.g., Cu) traces, or any other type of electrically-conductive elements. Interconnect features **44, 46** extend alongside one another in relatively close proximity for some distance. Magnetic fields are generated when signal-carrying currents (I₁, I₂) are directed through interconnect features **44, 46** and along signal paths **40, 42.** As was previously the case, the outer boundaries of portions of magnetic fields (Hi, H₂) are represented in FIG. 2 by dashed circles **48, 50;** again noting that only limited portions of the induced magnetic fields (Hi, H₂) are shown in FIG. 2 for clarity.

With continued reference to EM-shield microelectronic assembly **38** (FIG. 2), and in contrast to electrically-shielded microelectronic assembly **20** (FIG. 1), an intervening EM shield structure **52** is positioned between interconnect features **44, 46** and, therefore, between signal paths **40, 42.** Due to the properties of EM shield structure **52,** the core magnetic fields (Hi, H₂) generated during operation of assembly **38** do not extend significantly beyond EM shield structure **52** to impinge upon interconnect feature **44** and/or interconnect feature **46** located on the opposing side of shield structure **52** (or only do so to a greatly limited degree). EM shield structure **52** is at least partially composed of a magnetically-permeable material, which concentrates magnetic flux within layers **56** of structure **52** to limit the reach and overlap of the core magnetic fields (Hi, H₂). EM shield structure **52** can assume any form suitable for reducing magnetic cross-coupling and, more generally, EM cross-coupling between interconnect features **44, 46** in this manner. For example, in certain embodiments, EM shield structure **52** may assume the form of a monolithic wall or structure similar to electrical shield **34** (FIG. 1), but composed of a material having a relatively high magnetically-permeability. In more complex embodiments, and as depicted in FIG. 2, EM shield structure **52** includes at least one electrical shield portion or layer **54,** which is bonded to (or otherwise bought into contact or proximity with) at least one magnetic shield portion or layer **56,** as discussed more fully below.

Addressing first layer **54** of EM shield structure **52,** electrical shield layer **54** is composed of a material having a higher electrical conductivity and lower magnetic permeability than does magnetic shield layer **56.** In embodiments, electrical shield layer **54** is composed of a metallic material having an electrical conductivity less than 1 milli-Ohm millimeter at 20°C. Suitable materials include, but are not limited to, alloys containing one or more of the following as primary constituents by weight: Cu, Ni, aluminum (Al), silver (Ag), and gold (Au). As a still further possibility, electrical shield layer **54** may be composed of a material having moderate electrical conductivity and magnetic permeability properties. As indicated in FIG. 2 by symbol **58,** electrical shield layer **54** may be electrically grounded to, for example, reduce eddy currents loses, hysteresis effects, and RF mismatch (when applicable). In other embodiments, layer **54** may not be electrically grounded.

Magnetic shield layer **56** may be composed of any magnetically-permeable material (or combination of magnetically-permeable materials) having a magnetic permeability greater than electrical shield layer **54** and an electrical conductivity less than layer **54.** As appearing herein, a particular material (e.g., the material from which magnetic shield layer **56** is formed in the example of FIG. 2) is considered to have a magnetically permeability greater than another material (e.g., the material from which electrical shield layer **54** is formed in the example of FIG. 2) when the relative magnetic permeability (µᵣ) of the particular material exceeds the relative magnetic permeability (µᵣ) of the other material by at least 1%. Similarly, a particular material (e.g., the material from which magnetic shield layer **56** is formed) is considered to have an electrical conductivity less than another material (e.g., the material from which electrical shield layer **54** is formed) when the particular material has an electrical resistivity that is at least 1% greater than electrical resistivity of the other material at 20°C. The foregoing definitions apply throughout this document. Further, it will often be the case that a relatively large disparity will exist between the respective magnetically permeabilities and electrical conductivities of the magnetic shield layer(s) and electrical shield layer(s) included in a given EM shield structure. Accordingly, in embodiments, the magnetic permeability of magnetic shield layer **56** will be at least 50% greater and, preferably, at least twice the magnetic permeability of electrical shield layer **54.** Additionally or alternatively, the electrical conductivity of electrical shield layer **54** may be at least 50% greater, if not at least twice the electrical conductivity of magnetic shield layer **56** in implementations. In still other embodiments, the respective magnetically permeabilities and electrical conductivities of layers **54, 56** may vary by a greater or lesser amount.

With continued reference to FIG. 2, in certain embodiments, each magnetic shield layer **56** may be composed of one or more materials having a relative magnetic permeability (µᵣ) exceeding 1000 and possibly exceeding 10,000. Suitable materials include, but are not limited to, metallic materials including Mu metals, Fe-based alloys (e.g., permalloy), ferrites, electrical steels, amorphous metal alloys, and other alloys having relatively high magnetic permeabilities. Composite materials containing magnetically-permeable particles, fibers, or the like can also be utilized in embodiments. For example, in certain implementations, magnetic shield layer **56** can be produced from a molded material (e.g., an injection molded polymer) containing particles composed of ferrite, Fe, Mu metal, or another magnetically-permeable material. Due to the relatively high magnetic permeability of magnetic shield layer **56,** magnetic flux is concentrated within and is principally directed through layer **56,** rather than passing freely through structure **52,** to prevent the impingement of the core magnetic fields (Hi, H₂) onto features **44, 46** on the opposite side of the structure **52.** As a result, relatively little, if any magnetic cross-coupling occurs during assembly operation. Thus, taken in combination, electrical shield layer **54** and magnetic shield layer **56** provide a comprehensive and highly effective safeguard against EM cross-coupling that may otherwise occur during operation of microelectronic assembly **38.**

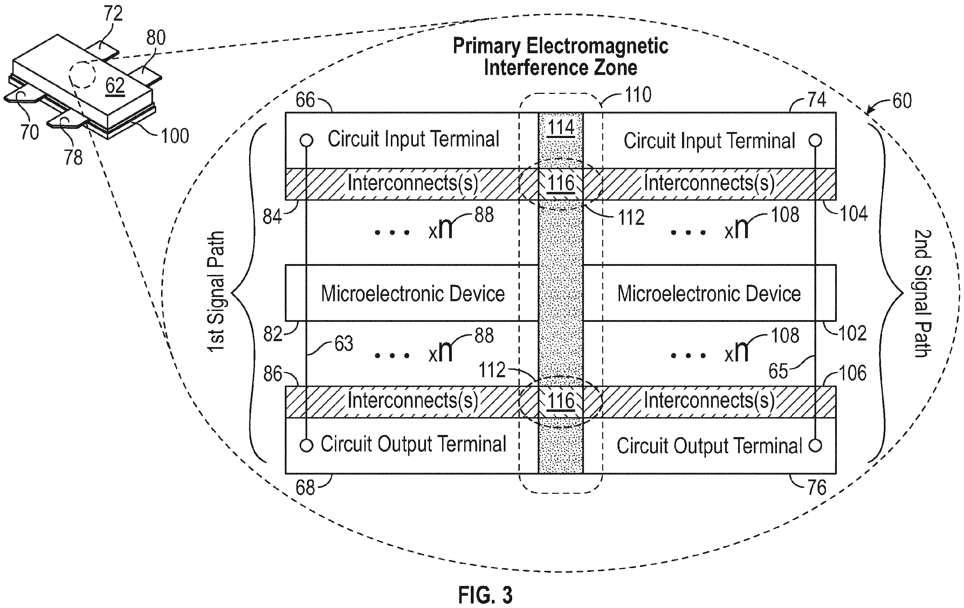

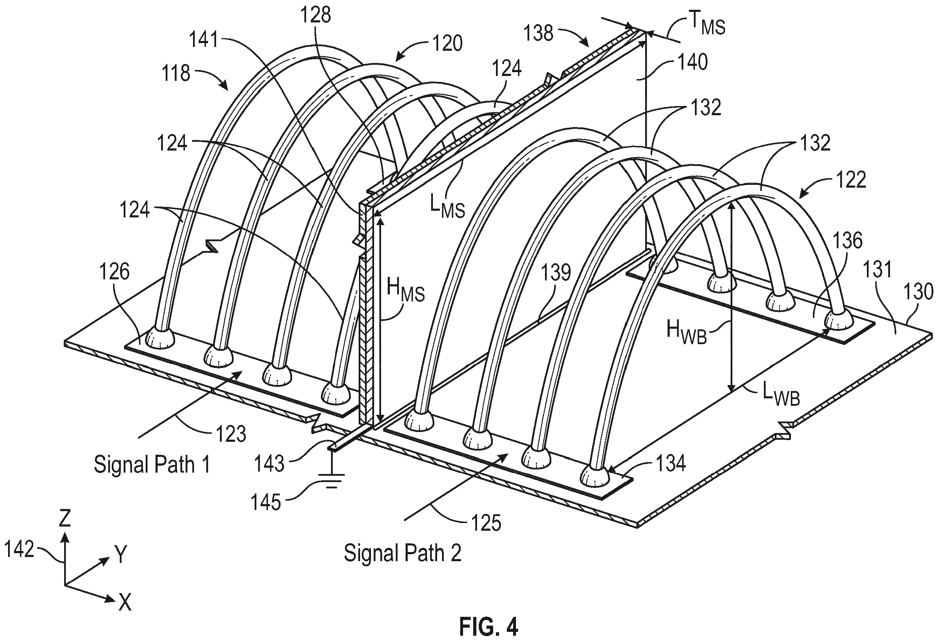

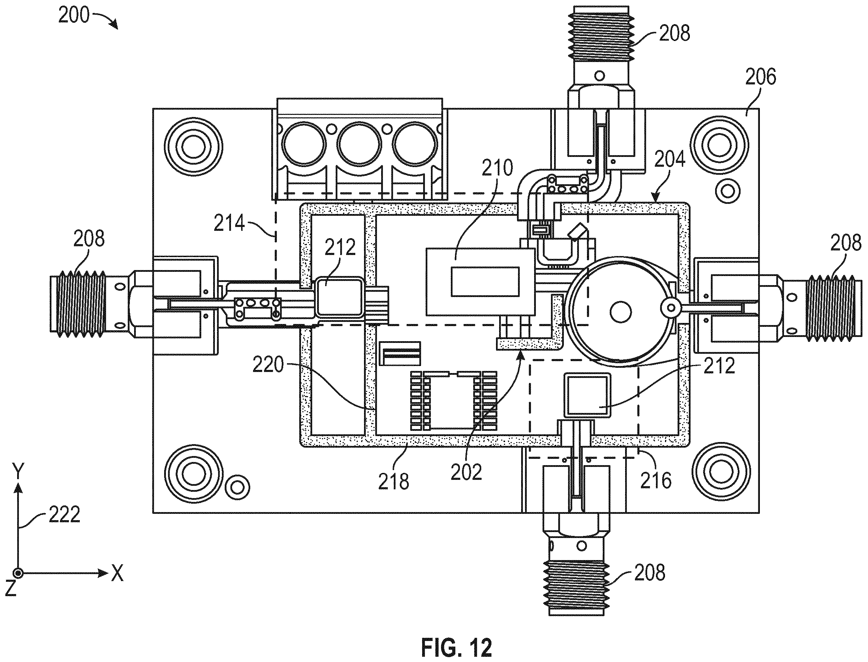

The teachings of FIG. 2 are usefully applied to EM shield structures on a package level, a module level, a system level, or other global level. Further, EM shield structure **52** shown FIG. 2 and the other EM shield structures disclosed herein, can be positioned between any current-conducting components or circuit elements through which separate or distinct (e.g., electrically-parallel) signal paths extend. A non-exhaustive list of such components includes active microelectronic devices (e.g., semiconductor and Microelectromechanical systems (MEMS) die), passive microelectronic devices (e.g., Surface Mount Devices (SMDs) and integrated passive devices), and interconnect features, such as interconnect lines (e.g., metal traces), wirebonds, and other such features utilized for electrical interconnection purposes. Several exemplary implementations of EM shield structures, which are positioned between bondwire arrays, are discussed set-forth in conjunction with FIGs. 4-11. First, however, an exemplary description is provided in conjunction with FIG. 3 of a microelectronic package into which one or more EM shield structures may be incorporated. The following notwithstanding, further embodiments of the EM shield structures can be incorporated into various other types of microelectronic assemblies including modules and systems, such as a massive MIMO module of the type further discussed below in conjunction with FIG. 12.

Advancing to FIG. 3, an electromagnetically-shielded circuit structure **60** (hereafter, "EM-shielded circuitry **60")** is schematically depicted in accordance with an exemplary embodiment of the present disclosure. EM-shielded circuitry **60** is usefully integrated into a microelectronic assembly, such as a module or a microelectronic package **62** shown in the upper left of FIG. 3. In this particular example, microelectronic package **62** assumes the form of a leaded air cavity package; however, in alternative implementations, microelectronic package **62** may assume various other forms, such as that of a no-lead package or a molded package having a different lead type. The functionalities provided by EM-shielded circuitry **60** will vary widely among embodiments, as appropriate to satisfy a particular application or usage; however, by way of non-limiting example, circuitry **60** may provide RF PA functionalities in one possible implementation, while microelectronic package **62** may assume the form of an N-way PA implemented utilizing one or more (i.e., N) high gain transistor die, such as laterally-diffused metal-oxide-semiconductor (LDMOS), GaN, or gallium arsenide (GaAs) transistors, arranged in N parallel amplification paths.

EM-shielded circuitry **60** includes a first signal path **63** and a second signal path **65,** which extend at least partly through circuitry **60** and carry electrical signals in parallel during circuit operation. Signal paths **63, 65** may extend through the entirety of microelectronic package **62** and, therefore, between the input/output (I/O) terminals (leads or pins) of microelectronic package **62.** Specifically, signal path **63** may extend from an input terminal **66** to an output terminal **68** of circuit **60,** which may correspond with an input lead **70** and output lead **72** of microelectronic package **62,** respectively, as further labeled in the upper left corner of FIG. 3. Similarly, signal path **65** may extend from an input terminal **74** to an output terminal **76** of circuitry **60,** which may correspond with an input lead **78** and output lead **80** of microelectronic package **62,** respectively. In further embodiments, circuitry **60** may include a different number of signal paths, input terminals, and output terminals, or may otherwise vary with respect to the illustrated example.

As generically shown in FIG. 3, at least one microelectronic device **82** is positioned in signal path **63** and electrically interconnected between terminals **66, 68** of circuitry **60.** Microelectronic device **82** can be, for example, a semiconductor die carrying integrated circuitry, such as RF circuitry; e.g., an RF power transistor with a control (input) terminal electrically connected to input terminal **66,** and a current-carrying (output) terminal electrically connected to output terminal **68** Selected terminals, such as bond pads, of microelectronic device **82** may be electrically coupled to circuit input terminal **66** by one or more interconnect features **84.** Interconnect features **84** may assume the form of, for example, patterned metal (e.g., Cu, Al, or Au) traces, three-dimensionally (e.g., ink jet) printed traces, bondwires, conductive vias, or various other electrically-conductive structures. Similarly, other terminals of microelectronic device **82** are electrically coupled to circuit output terminal **68** by one or more interconnect features **86,** which again may be bondwires, metal traces, or other electrical conductors utilized for interconnection purposes.

Microelectronic device **82** may be directly interconnected to either or both of terminals **66, 68** in embodiments. Alternatively, and as indicated in FIG. 3 by symbols **88,** any number of intervening microelectronic devices and interconnect features may be further provided in signal path **63** between terminals **66, 68.** For example, in one realization of circuitry **60,** microelectronic device **82** assumes the form of an active semiconductor die, such as an RF semiconductor power transistor die, which is directly connected with terminals **66, 68** by interconnect features **84, 86** in the form of bondwires or bondwire arrays. In such embodiments, the RF semiconductor die may further be electrically coupled to electrical ground through an electrically-conductive substrate or base flange **100** also contained in package **62,** as further indicated in the upper left corner of FIG. 3. Alternatively, in other implementations, microelectronic device **82** may not be directly connected to terminals **66, 68,** but rather electrically coupled to one or more passive devices, such as SMD or integrated passive devices (e.g., capacitor structures), further contained within or integrated into microelectronic package **62.** Any such passive devices may be electrically coupled to terminals **66, 68,** in turn, to complete the desired circuit structure. Numerous other circuit architectures are also possible, with circuitry **60** suitably containing any number and type of active devices (e.g., semiconductor die and MEMS die), passive devices (e.g., integrated passive devices and SMDs), and other such devices (e.g., RF antenna or shield structures) electrically interconnected between terminals **66, 68** to form signal path **63,** as desired.

In the illustrated example of FIG. 3, the circuit elements defining second signal path **65** of circuitry **60** are similar or identical to those defining first signal path **63.** Thus, as was previously the case, at least one microelectronic device **102** (e.g., a semiconductor die) is electrically coupled, whether directly or indirectly, to circuit input terminal **74** via a first interconnect feature **104,** such as a first bondwire array. Microelectronic device **102** is further electrically coupled, directly or indirectly, to circuit output terminal **76** via a second interconnect feature **106,** such as a second bondwire array. Once again, and as schematically indicated by symbols **108,** any number and type of additional microelectronic devices and interconnect features can likewise be provided between microelectronic device **102** and terminals **74, 76** to form the desired circuit structure. For example, in embodiments in which microelectronic package **62** assumes the form of a dual path RF power amplifier, microelectronic devices **82, 102** maybe high power (e.g., LDMOS or GaN) transistor die, and one or more sets of integrated capacitors may potentially be electrically interconnected between devices **82, 102** and corresponding circuit terminals **66, 68, 74, 76.** In such embodiments, one of signal paths **63, 65** may be formed by the peaking transistor elements of a Doherty PA or other multi-path amplifier, while the other of signals paths **63, 65** is formed by the carrier transistor elements of a Doherty PA or other multi-path amplifier. Again, numerous other circuit layouts are also possible in further implementations, with the schematic of FIG. 3 provided by way non-limiting example only.

Due to the relative close physical spacing of the electrically-conductive circuit elements defining circuit path **63** (namely, input terminal **66,** interconnect feature **84,** microelectronic device **82,** interconnect feature **86,** and output terminal **68**) and the electrically-conductive circuit elements defining parallel circuit path 65 (namely, input terminal **74,** interconnect feature **104,** microelectronic device **102,** interconnect feature **106,** and output terminal **76**)**,** EM cross-coupling can occur during operation of circuitry **60.** Depending upon its severity, EM cross-coupling can potentially detract from certain aspects of circuit performance and, more broadly, from the overall performance of microelectronic package **62.** For example, EM cross-coupling and, particularly, the magnetic component of EM cross-coupling can displace the impedances presented to the transistor die (e.g., devices **82, 102**), which may, in turn, limit RF performance (when applicable) in terms of linearity, efficiency, peak power, gain, or any combination thereof. EM cross-coupling may principally occur when induced EM fields extend across a primary EM interference zone **110** between parallel circuit paths **63, 65**. Specifically, it has been determined that undesired EM cross-coupling may be problematic when crossing localized regions **112** to impinge upon an opposing one of interconnect features **84, 104** and/or an opposing one of interconnect features **86, 106** in at least some implementations of circuitry **60.** Undesired EM cross-coupling may result negatively impacting the performance of circuitry **60;** e.g., in circuit terms, for example, a mutual inductance or mutual capacitance may develop and alter the currents and voltages of the signals conducted through circuit paths **63, 65.**

To decrease EM cross-coupling during operation of circuitry **60** and package **62,** a single, elongated EM shield structure **114** may be positioned in primary EM interference zone **110** between the circuit elements defining signal paths **63, 65.** In various embodiments, EM shield structure **114** may assume the form of a wall, fin, or freestanding strip composed of a magnetically-permeable material, such as Mu metal, permalloy, or ferrite; potentially bonded to or otherwise joined to (or positioned in an abutting relationship or close proximity with) another strip or wall of an electrically-conductive material of the type previously discussed. For example, in certain implementations, EM shield structure **114** may have a construction similar or analogous to that of EM shield structure **52** shown in FIG. 2. In embodiments, EM shield structure **114** may extend the entire length (and, perhaps, slightly beyond) primary EM interference zone **110.** In other embodiments, multiple, smaller EM shield structures **116** may be disposed in a more targeted manner in localized regions (including but not limited to regions **112**) between adjacent sets of interconnect features; e.g., a first structure **116** may be positioned between features **84,104** and a second structure **116** may be positioned between features **86, 106.** As a still further possibility, a combination of these approaches can be employed such that a relatively lengthy EM shield structure may extend the length of zone **110,** while the magnetic isolation properties of the shield structure may be enhanced in localized regions **112** by, for example, providing an increased volume of magnetically-permeable material in these regions. Several exemplary implementations of the EM shield structures will now be discussed in conjunction with FIGs. 4-11. Notably, the below-described shield structures can be utilized in various combinations in embodiments of EM-shielded microelectronic package **62** and the other EM-shielded microelectronic assemblies described herein, including the massive MIMO module discussed below in connection with FIG. 12. Considering this, the exemplary embodiments set-forth below are not mutually exclusive unless otherwise stated.

Initially addressing the exemplary implementation shown in FIG. 4, a limited portion of an EM-shielded microelectronic assembly **118** is depicted in accordance with an exemplary embodiment of the present disclosure. Microelectronic assembly **118** includes at least two separate signal paths **123, 125,** which extend in parallel (in an electrical sense and, perhaps, in a spatial or geometric sense) through the illustrated portion of assembly **118.** Additionally, microelectronic assembly **118** includes first and second interconnect features **120,122** through which signal paths **123, 125** extend. In this example, interconnect features **120, 122** are illustrated as bondwire arrays and will consequently be referred to hereafter as "bondwire arrays **120, 122,"** respectively. In further embodiments, bondwires arrays **120, 122** may each be replaced by a single bondwire or a different type of electrical conductor, such one or more metal traces. In embodiments, microelectronic assembly **118** may correspond to microelectronic package **62** shown in FIG. 3, in which case signal paths **123, 125** may correspond to signal paths **63, 65,** while interconnect features **120, 122** correspond to interconnect features **84, 104** or interconnect features **86, 106,** respectively.

Bondwire array **120** includes a plurality of bondwires **124,** which are arranged in a grouping or row spaced along a lateral axis in FIG. 4 (corresponding to the X-axis identified by coordinate legend **142**)**.** Bondwires **124** each extend between two points of contacts, here bond pads **126, 128,** provided on an upper principal surface or frontside **131** of an assembly substrate **130.** Similarly, bondwire array **122** includes a plurality of bondwires **132,** which are arranged in a row and extend between bond pads **134, 136** further provided on frontside **131** of substrate **130.** Bond pads **126, 128, 134, 136** and substrate **130** are provided by way of example only, with the understanding that bondwire arrays **120, 122** can extend between and electrically connect various different types of terminals or points-of-contact. For example, in alternative embodiments, bondwire arrays **120,122** may each extend from bond pads provided on semiconductor die or other microelectronic devices (e.g., devices **82, 102** shown in FIG. 3) to a bond pad shelf or other dedicated point-of-contact within a microelectronic package, module, or system. Assembly substrate **130** can be a flange, a printed circuit or wiring board, or any other supportive body, which may or may not contain electrical routing features. Again only a limited region of substrate **130** is depicted in FIG. 4, noting that EM-shielded microelectronic assembly **118** will further include various other circuit elements and interconnect features not shown for illustrative clarity.

A wall-like EM shield structure **138** is disposed between bondwire arrays **120, 122,** with arrays **120, 122** located on opposing sides of structure **138.** EM shield structure **138** physically separates or partitions arrays **120, 122,** as taken along a lateral axis parallel to substrate frontside **131** (corresponding to the X-axis of coordinate legend **142**)**.** In the illustrated example, EM shield structure **138** includes at least two distinct portions or regions: (i) an electrical shield portion or layer **140,** and (ii) a magnetic shield portion or layer **141.** Electrical shield layer **140** and magnetic shield layer **141** may assume the form of continuous or non-patterned layers, which are bonded or otherwise joined to form a bilayer wall. In other embodiments, electrical and magnetic shield layers **140, 141** may not be directly bonded, but rather positioned adjacent one another as taken along the lateral axis and, perhaps, brought into physical contact; e.g., shield layers **140, 141** may be pressed or clamped together in some fashion.

Magnetic shield layer **140** may be composed of a magnetically-permeable material, such as a Mu metal, an Fe-based alloy (e.g., a permalloy), an electrical steel, or the other materials described herein. Alternatively, magnetic shield layer **141** can be composed of a composite material containing magnetically-permeable (e.g., Fe or ferrite) particles or other filler; or any other material having a relative magnetic permeability (µᵣ) exceeding 1000 and, more preferably, exceeding 10,000. In other embodiments, layer **141** may be composed of a material having a magnetic permeability equal to or greater than 80,000 Henries per meter. Comparatively, electrical shield layer **140** can be composed of any material having an electrical conductivity greater than magnetic shield layer **141** and a magnetic permeability less than layer **140.** Further, in embodiments, electrical shield layer **140** may be composed of a material having an electrical conductivity at least 50% greater, if not at least twice the electrical conductivity of the material from which magnetic shield layer **141** is composed; while magnetic shield layer **141** may be composed of a material having a magnetic permeability at least 50% greater, if not at least twice the magnetic permeability of the material from which electrical shield layer **140** is composed. A non-exhaustive list of suitable materials for forming all or a portion of electrical shield layer **140** include metals and alloys containing Cu, Ni, Al, Au, Ag, or any combination thereof as primary constituents, by weight. As indicated in FIG. 4 by symbol **145,** electrical shield layer **140** may be coupled to electrical ground by, for example, a grounded conductor **143,** such as a metal trace, a plated via, or ground plane. Grounding of electrical shield layer **140** may help reduce any eddy current loses and provide other performance benefits during operation of assembly **118,** as discussed below. In other embodiments, electrical shield layer **140** may not be grounded.

The dimensions, composition, and construction of EM shield structure **138** will vary among embodiments and can be tailored to provide a desired level of magnetic shielding between bondwire arrays **120, 122** and, more generally, different signal paths **123, 125.** In at least some embodiments, EM shield structure **138** may extend along the Y-axis of legend **142** for a distance well-beyond that shown in FIG. 4 to provide magnetic isolation between other adjacent interconnect features contained in signal paths **123, 125.** For example, EM shield structure **138** can potentially be dimensioned to extend the entirety or the substantial entirety of primary magnetic interference zone **110** in FIG. 3. Alternatively, EM shield structure **138** may not extend the entirety of magnetic interface zone **110;** and EM shield structure **138** may instead be imparted with reduced dimensions, with multiple instances of structure **138** incorporated into EM-shielded circuitry **60.** Regardless, EM shield structure **138** may be joined to substrate **130** in various manners, with structure **138** oriented such that the opposing principal surfaces of structure **138** form essentially right angles with substrate frontside **131.** For example, EM shield structure **138** maybe separately fabricated from substrate **130** and brazed or bonded thereto utilize a die attach material, an epoxy, a sintered metallic material, or other adhesive. Moreover, in certain embodiments, a lower portion or edge of structure **138** may be matingly received within a shallow trench **139** formed in frontside **131** of substrate **130** for added support.

With continued reference to FIG. 4, EM shield structure **138** has a peak height H_{MS}, as measured along an axis orthogonal to frontside **131** of substrate **130** and parallel to the Z-axis of coordinate legend **142;** a maximum length L_{MS}, as measured along an axis parallel to substrate **130** and to the Y-axis of coordinate legend **142;** and an average thickness T_{MS}, as measured along an axis parallel to substrate **130** and to the X-axis of legend **142.** As indicated above, H_{MS}, L_{MS}, and T_{MS} will vary among embodiments and need not be held constant across the entirety of EM shield structure **138.** Generally, however, H_{MS} will often be equal to or greater than the peak height of bondwire arrays **120, 122,** as identified in FIG. 4 by double-headed arrow "H_{WB}" and again measured along an axis orthogonal to substrate frontside **131.** Similarly, L_{MS} will often be equal to or greater than the maximum length of one or both of bondwire arrays **120, 122,** as identified in FIG. 4 by double-headed arrow "L_{WB}" and measured along an axis parallel to the Y-axis of coordinate legend **142.** Dimensioning EM shield structure **138** in this manner may better accommodate the reach of the magnetic fields induced when signal-carrying electrical currents are passed through arrays **120, 122,** to maximize the effectiveness of structure **138.**

The thickness of EM shield structure **138** may be constant or, instead, may vary to provide enhanced magnetic shielding in regions of greater flux line concentration. In one embodiment, EM shield structure **138** has an average thickness (T_{MS}) ranging from 1 to 100 millimeters (mm) and, more preferably, from 5 to 50 mm. In such embodiments or in other embodiments, magnetic shield layer 141 may make-up or comprise at least half the thickness of EM shield structure **138** such that the thickness of layer **141** is equal to or greater than the thickness of electrical shield layer **140** and, perhaps, at least twice the thickness of layer **140.** As a more specific example, and without loss of generality, magnetic shield layer **141** may make-up or comprise about 50% to about 90% of the total thickness of EM shield structure **138** (again, as measured along an axis orthogonal to a principal face of shield structure **138**), with electrical shield layer **140** making-up the remainder of the thickness of shield structure **138.** In still other embodiments, T_{MS} may be greater than or less than the aforementioned ranges and/or the relative thickness of layers **140, 141** may vary relative to the examples set-forth above.

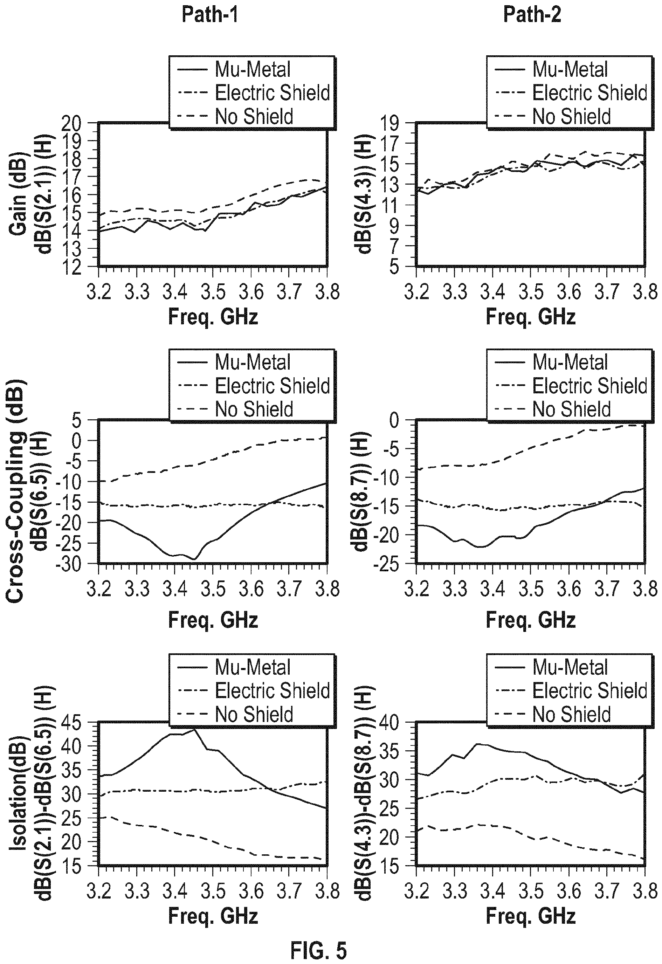

FIG. 5 graphically depicts simulated improvements in gain, cross-coupling, and isolation achieved by EM-shielded microelectronic assembly **118.** In this simulation, magnetic shield layer **141** of EM shield structure **138** (FIG. 4) is composed of a Mu metal and has a constant thickness of 10 mm, while electrical shield layer **140** is composed of a sheet of Cu and has an approximately equivalent thickness. Further, EM-shielded microelectronic assembly **118** is simulated as an RF circuit structure (e.g., a 2-way RF power amplifier) operable over a frequency range from 3.2 to 3.8 gigahertz. The performance of EM-shielded microelectronic assembly **118** (as represented by a first trace pattern in FIG. 5) is compared to a similar microelectronic assembly having an electrical (Cu) shield structure, but lacking a magnetically-permeable shield layer (represented by a second trace pattern) and a similar circuit lacking any shield structure (represented by a third trace pattern). As can be seen in the middle row of graphs presented in FIG. 5, magnetic cross-coupling between the two simulated signal paths is greatly reduced during assembly operation in the case of EM-shielded microelectronic assemblies **118** due to the provision of EM shield structure **138** (FIG. 4). Correspondingly, as indicated in the lower row of graphs, magnetic isolation between the different signal paths is significantly improved; e.g., the provision of EM shield structure **138** demonstrated isolation improvements over 10 decibels (dB) as compared to the microelectronic assembly containing an electrical (e.g., Cu) shield and over 20 dB as compared to the microelectronic assembly lacking any shield. Finally, as indicated in the upper row of graphs in FIG. 5, the inclusion of EM shield structure **138** (FIG. 4) within microelectronic assemblies **118** may provide minor, if not negligible detriments in gain.

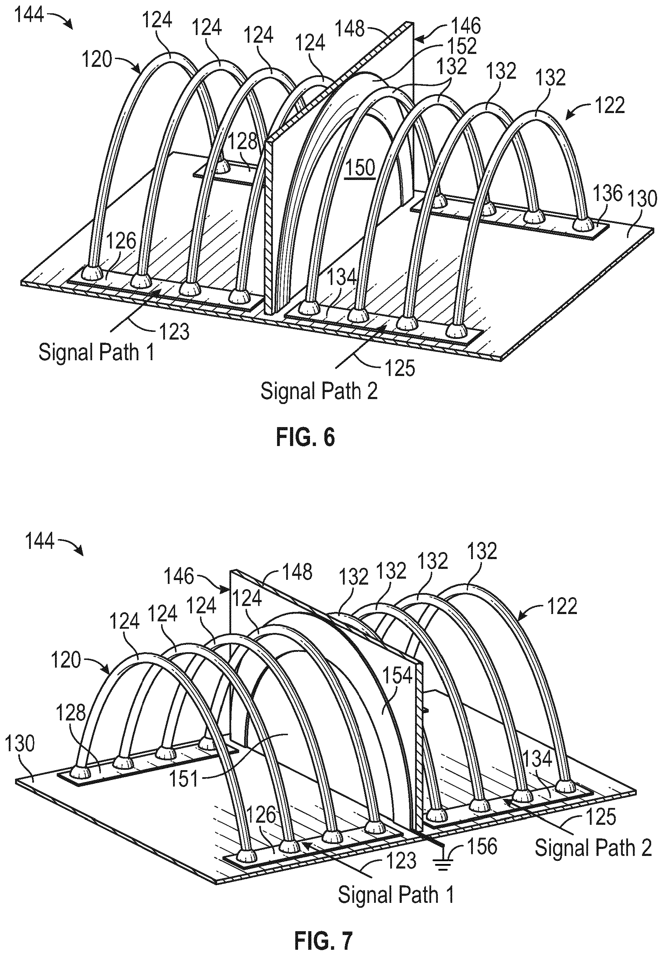

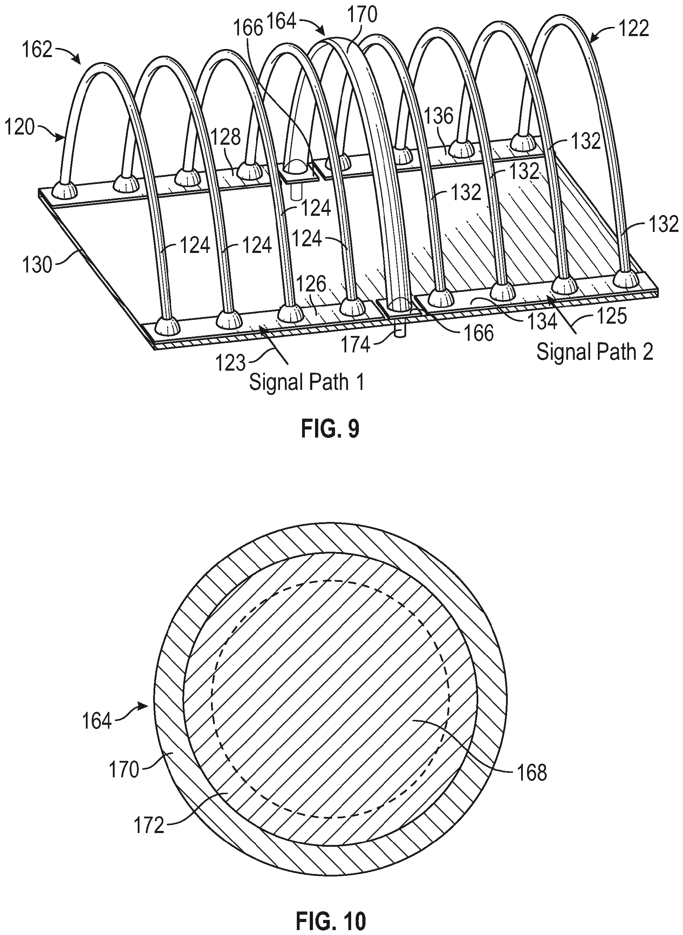

As described above, EM shield structure **138** has a relatively simple, dual layer construction in the embodiment of FIG. 4. Advantageously, such a construction may lower the costs and complexity of manufacture when producing structure **138.** EM shield structure **138** can be fabricated in various different manners. For example, in one approach, magnetic shield layer **141** may be cut (e.g., via laser cutting, water jetting, stamping, sawing, or the like) from a larger sheet of magnetically-permeable material, which is singulated into multiple shield structures. Examples such material are discussed above in conjunction with EM shield structure **52** shown in FIG. 2 and include Mu metals, Fe-based alloys (e.g., a permalloy), electrical steels, and various other alloys having relatively high magnetic permeabilities. Prior to or following singulation of the magnetically-permeable sheet, electrical shield layer **140** may be formed on magnetic shield layer **141** by, for example, plating or electrodepositing an electrically-conductive alloy on the magnetically-permeable sheet. Alternatively, electrical shield layer **140** may likewise be cut from a larger sheet or panel of electrically-conductive material and then bonded to magnetic shield layer **141** utilizing, for example, a die attach material, a sintered metallic material, a metal-filled epoxy, or the like. As a still further possibility, electrical shield layer **140** may initially be produced and then utilized as substrate onto which magnetic shield layer **141** is deposited; e.g., by plating, by sputter depositing, or other depositing a magnetically-permeable alloy onto selected surfaces of magnetic shield layer **141.** In such embodiments, electric shield layer **140** may also be considered a "substrate layer" or "shield substrate." In yet further embodiments, layers **140, 141** may not be directly bonded, but rather placed in intimate contact or close proximity. While the relatively simply construction of EM shield structure **138** may reduce cost, other advantages may be gained by fabricating structure **138** to have a more complex construction. For example, in further embodiments according to the claimed invention, the EM shield structure may include one or more patterned layers of magnetically-permeable material and/or electrically-conductive material, as discussed below in conjunction with FIGs. 6-8. In the examples illustrated by figures 9 and 10, the EM shield structure may include one or more shaped layers of magnetically-permeable material and/or electrically conductive material.

FIGs. 6 and 7 are isometric views of an EM-shielded microelectronic assembly **144** including an EM shield structure **146,** as illustrated in accordance with an embodiment according to the claimed invention. EM-shielded microelectronic assembly **144** is similar to EM-shielded microelectronic assembly **118,** with assemblies **118, 144** sharing several structural elements in common. Accordingly, the reference numerals previously introduced in conjunction with FIG. 4 have been carried-over to FIGs. 6 and 7, where appropriate, and the foregoing description of signal paths **123, 125,** bondwire arrays **120, 122,** and assembly substrate **130** applies equally. As was previously the case, EM shield structure **146** has a generally rectangular, wall-like or plate-like form factor in the illustrated example; and extends upwardly from the frontside of assembly substrate **130** between bondwire arrays **120, 122.** Stated differently, EM shield structure **146** forms a right angle with substrate **130** and physically partitions or separates bondwire arrays **120, 122,** as taken along an axis orthogonal to either of the opposing principal surfaces of structure **146.** Thus, once again, bondwire arrays **120, 122** are located on opposing sides of EM shield structure **146.** In further embodiments, EM shield structure **146** may have a more complex shape, such as a curved planform geometry or planform geometry defined by multiple intersecting walls.

In contrast to EM shield structure **138** contained in microelectronic assembly **118** shown in FIG. 4, EM shield structure **146** of microelectronic assembly **144** has a more complex, multilayered construction. Specifically, in the embodiments according to the claimed invention shown in FIGs. 6-7, EM shield structure **146** includes a dielectric substrate layer or shield substrate **148** having opposing principal surfaces **150, 151,** which face bondwire arrays **122, 120,** respectively. As shown most clearly in FIG. 6, a first patterned layer of magnetically-permeable material **152** (hereafter, "patterned magnetic shield layer **152")** is formed on principal surface **150** of substrate layer **148.** Similarly, and as indicated in FIG. 7, a patterned layer of an electrically-conductive material **154** (hereafter, "patterned electrical shield layer **154"**) may be formed on substrate surface **151** opposite patterned magnetic shield layer **152.** Layers **152, 154** are thus positioned adjacent one another, although separated by substrate layer **148,** and may also be referred to as indirectly bonded. **EM** shield structure **138** is thus similar or akin to a two-sided printed circuit board (PCB) or wiring board in the illustrated embodiment. According to the claimed invention, at least one of the magnetic shield layer and the electric shield layer is a pattern layer.

In further embodiments, shield structure **138** can include a greater number or lesser number of patterned or non-patterned (continuous) layers.

Substrate layer **148** can be composed of a metallic material, a dielectric material of the type commonly utilized in PCB production (e.g., polytetrafluoroethylene or a polyimide), a ceramic, or another material. Patterned magnetic shield layer **152** can be deposited onto principal surface **150** of substrate layer **148** in different manners, with the selected deposition process depending upon the composition of substrate layer **148,** the composition of shield layer **152,** the desired thickness of shield layer **152,** and other such factors. For example, patterned magnetic shield layer **152** can be electroplated onto substrate surface **150** as a magnetically-permeable (e.g., Fe-rich) plating. In other embodiments, patterned magnetic shield layer **152** can be applied onto surface **150** of substrate layer **148** utilizing a film transfer process, as a B-stage epoxy, or via silkscreen application. In this latter regard, a wet-state material (e.g., a paste, paint, or slurry) may be prepared or otherwise obtained to include magnetically-permeable particles dispersed in a liquid carrier or solvent, such as water or a high molecular weight alcohol. The wet-state material may also contain other constituents, such as organic additives (e.g., an acrylic), added for strengthen purposes. After application of the wet-state material to substrate surface **150** utilizing a suitable process (e.g., a silkscreen process or another deposition process capable of depositing a flowable material in a desired pattern, such as fine needle dispense), the wet-state material may then be thermally processed (e.g., dried and possibly baked) to remove some or all of the organic fraction from the wet-state material, thereby producing patterned magnetic shield layer **152.**

With continued reference to FIGs. 6-7, and as shown most clearly in FIG. 7, patterned electrical shield layer **154** can be formed on substrate surface **151** utilizing the various different deposition processes described above in conjunction with patterned magnetic shield layer **152.** In other embodiments, patterned electrical shield layer **154** may be fabricated utilizing well-known metal deposition and lithography techniques, such as those commonly utilized to produce metal traces on circuit boards. Further, if desired, patterned electrical shield layer **154** may be electrically grounded by, for example, electrically coupling patterned electrical shield layer **154** to a grounded trace, conductive via, coin, or other electrically-grounded interconnect feature, as indicated in FIG. 7 by symbol **156.** As noted above, grounding of layer **154** may help reduce eddy current loses and provide other performance benefits. The composition and thickness of patterned electrical shield layer **154** will vary among embodiments; however, in one embodiment, electrical shield layer **154** is at least principally composed of Cu, Al, or Au, by weight, and has a thickness between 0.01 and 10 mm. More generally, electrical shield layer **154** will typically be composed of material having a greater electrical conductivity, but a lower magnetic permeability than does magnetic shield layer **152** (FIG. 6). For example, in certain embodiments and in a manner akin to that previously described, electrical shield layer **154** may be composed of a material having an electrical conductivity at least 50% greater, if not at least twice the electrical conductivity of the material from which magnetic shield layer **152** is composed; while magnetic shield layer **152** may be composed of a material having a magnetic permeability at least 50% greater, if not at least twice the magnetic permeability of the material from which electrical shield layer **154** is composed.

Several benefits are realized by forming EM shield structure **146** to include patterned shield layers **150, 152** in the above-described manner, rather than by forming structure **146** to contain non-patterned, continuous layers. First, some level of cost reduction may be achieved via the reduced volume of shield layers **150, 152,** particularly when more costly materials are utilized to produce one or both of shield layers **150, 152.** Second, by minimizing the shielding material surface area, issues such as RF mismatch, reduced bondwire Q (potentially resulting in increased eddy current losses in the shield structure), and memory effects (hysteresis), can be significantly reduced, if not essentially avoided. These notwithstanding, one of the layers **150, 152** may be provided as a non-patterned layer or sheet in further embodiments according to the claimed invention. In an alternative example which does not form part of the claimed invention, electrical shield layer **154** may be formed as a continuous sheet or wall, while magnetic shield layer **152** maybe directly bonded to layer **154** as a patterned layer similar or identical to that shown in FIG. 6.

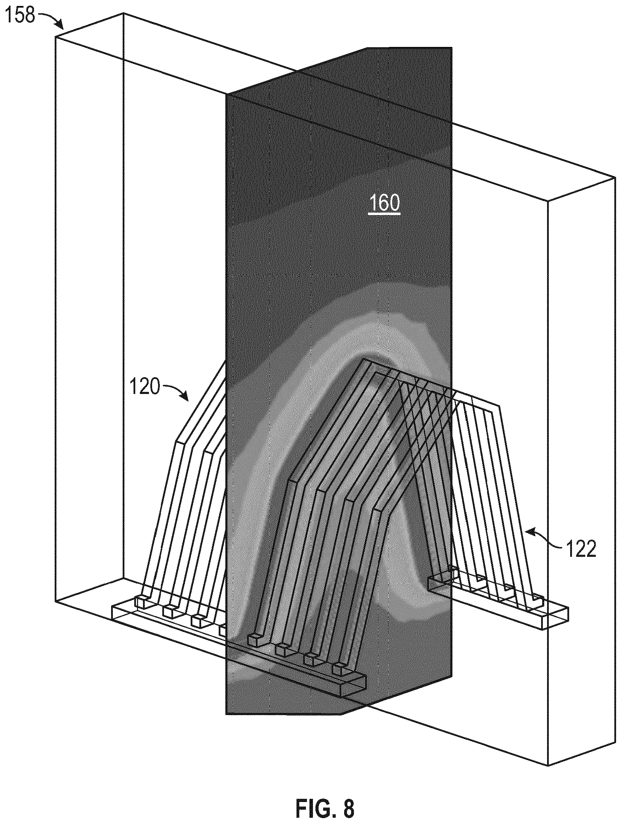

When provided as a patterned layer, magnetic shield layer **152** is usefully spatially distributed in those regions in which flux concentration is greatest. The particular pattern in which magnetic shield layer **152** is deposited can be selected to generally mimic or mirror the arch-shaped bondwire profile of bondwires **124,** bondwires **132,** or both bondwires **124, 132,** as viewed along an axis orthogonal to substrate surfaces **151, 152.** Stated differently, bondwires **124, 132** may be bent into a curved shape as shown, while magnetic shield layer **152** (and possibly electrical shield layer **154**) is patterned to have a planform geometry corresponding to or approximating the curved shape of bondwires **124, 132**); the term "planform geometry," as appearing herein, referring to the geometry of layer **152** (or layer **154,** as the case may be) viewed along an axis orthogonal to substrate surfaces **151, 152.** Additionally or alternatively, data may be gathered, whether by computer simulation or utilizing a physical testing apparatus, to plot the flux line concentration in a plane orthogonal to the frontside of substrate **130** and, perhaps, parallel to, if not coplanar with principal surface **150** of substrate layer **148** (FIG. 6). An example of such a computer simulation **158** is shown in FIG. 8, with varying flux line concentrations within a plane **160** indicated by varying colors (represented by varying shading levels in the drawing). Such simulation data **158** can thus be utilized to define the dimensions and shape of patterned magnetic shield layer **152** by judiciously distributing the magnetic shield material in those regions of greatest flux line concentration and, thus, most susceptible to magnetic cross-coupling. Further, if desired, the thickness of magnetic shield layer **152** can be varied in accordance with such mapped flux concentration data; e.g., such that the local thickness of magnetic shield layer **152** is increased in regions of peak flux line concentration, as generally shown in FIG. 6.

In the above-described manner, the provision of EM shield structure **146** can improve magnetic isolation rates during operation of microelectronic assembly **144;** e.g., testing data indicates that isolation rates approaching or exceeding 15 dB can be achieved in at least some embodiments of assembly **144.** Concurrently, patterning and possible grounding of electrical shield layer **154** can provide performance benefits, such as reduced eddy current losses, as discussed above. EM shield structure **146** can still be fabricated utilizing a batch manufacturing process, if desired; e.g., structure **146** can be produced in parallel with a plurality of like structures by forming patterned layers on opposing sides of a larger panel, which contains dielectric substrate layer **148** and which is subsequently singulated into smaller pieces. In other embodiments, dielectric substrate layer **148** could be replaced with a non-patterned or continuous electric shield layer (with patterned magnetic shield layer **152** formed on one or both sides of the electrical shield layer); or, alternatively, dielectric substrate layer **148** could be replaced with a non-patterned magnetic shield layer (with electrical shield layer **154** formed on one or both sides of the magnetic shield layer).

Although including a patterned magnetic shield layer **152** in the example of FIGs. 6-8, EM shield structure **146** still possess a relatively simple wall-like or fin-like form factor similar to EM shield structure **138** described above in connection with FIGs. 4-5. Further embodiments of the EM shield structure can assume other forms, however, providing that at least a portion of the shield structure is physically positioned between adjacent interconnect features, devices, or other circuit elements included in separate signal paths and is at least partially composed of a magnetically-permeable material. For example, in alternative implementations which do not form part of the claimed invention, EM shield structure can be produced as a wire fence at least partially composed of a magnetically-permeable material, as described below in conjunction with FIGs. 9 and 10.

Continuing to FIG. 9, an EM-shielded microelectronic assembly **162** is shown in accordance with a further exemplary embodiment of the present disclosure. Once again, like reference numerals utilized in describing FIGs. 4, 6, and 7 have been carried forward to FIG. 9, where appropriate. In this example, EM-shielded microelectronic assembly **162** includes an EM shield structure **164,** which is formed as an arch-shaped wire mimicking or following the bond wire profile of bondwires **124, 132.** In other words, EM shield structure **164** is imparted with a curved shape, which generally matches, follows, or corresponds to the curved shape of bondwires **124, 132.** In certain embodiments, EM shield structure **164** may be wholly composed of a magnetically-permeable material and bonded to bond pads **166.** In this case, EM shield structure **164** can be formed utilizing a wirebonding tool, but substituting a wire feed composed of a magnetically-permeable metal or alloy (e.g., a Mu metal) for the electrically-conductive material (e.g., Au, Ag, or Cu) typically utilized in bondwire formation. Alternatively, in such embodiments, EM shield structure **164** may be produced utilizing a three dimensional printing process. In still other embodiments, EM shield structure **164** may contain an electrically-conductive wire core over which a magnetically-permeable coating is applied. This latter possibility is indicated in FIG. 10, which is a cross-section through EM shield structure **164** revealing an electrically-conductive (e.g., Cu, Au, or Ag) wire core **168** surrounded by a magnetically-permeable (e.g., Mu metal) wire coating **170.** Additionally, as indicated in phantom in FIG. 10, a cladding **172** may be provided around wire core **168** in embodiments (e.g., a stainless steel- or nickel-clad Cu wire may be utilized), in which case magnetically-permeable wire coating **170** may be adhered to cladding **172.**

In embodiments in which EM shield structure **164** contains an electrically-conductive wire core **168** (FIG. 10), wire core **168** may be electrically coupled to ground through bond pads **166** and interconnect features **174** (FIG. 9), such as metal traces, conductive vias, metal plugs, or the like formed in substrate **130.** Again, grounding of wire core **168** in this manner may help reduce eddy current losses within EM shield structure **164** during operation of microelectronic assembly **162.** Magnetically-permeable wire coating **170** can be applied to wire core **168** before or after bonding to bond pads **166.** For example, in embodiments, a wet-state application technique is utilized to apply a precursor material (e.g., a paste or paint) containing magnetically-permeable particles to wire core **168;** and then a curing process (e.g., heat treatment) is conducted to convert the precursor material into wire coating **170** by, for example, removing some or all of the organic materials (e.g., a liquid carrier and any organic binders) therefrom. In other embodiments, a different application technique can be utilized; or, as noted above, EM shield structure **164** may be entirely composed of a magnetically-permeable material.

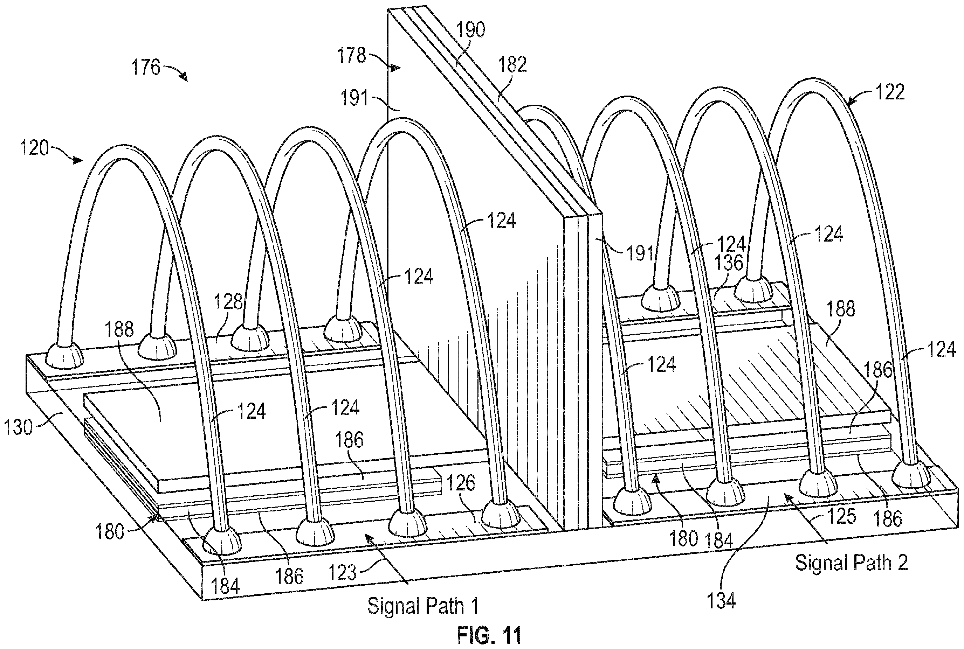

Advancing next to FIG. 11, there is shown an EM-shielded microelectronic assembly **176** including an EM shield structure **178,** as depicted in accordance with a still further exemplary embodiment of the present disclosure. Once again, EM-shielded microelectronic assembly **176** is similar to microelectronic assemblies **118, 144, 162** described above in conjunction with FIGs. 4-10, with reference numerals carried forward where appropriate. However, in contrast to above-described EM-shielded microelectronic assemblies **118, 144, 162,** EM-shielded microelectronic assembly **176** further includes two microelectronic devices **180** located on opposing sides of a main body or shield wall **182** of EM shield structure **178,** which is oriented to extend substantially orthogonally to the upper principal surface or frontside of substrate **130,** as previously described. In this particular example, microelectronic devices **180** are depicted as integrated capacitor structures. Accordingly, microelectronic devices **180** each include a dielectric layer **184** separating two electrically-conductive layers **186,** as formed in substrate **130** (shown in phantom to better reveal devices **180**) at location beneath shield structure **178** as taken along an axis orthogonal to the frontside of substrate **130.** In other embodiments, microelectronic devices **180** can assume other forms, such as chip caps or other passive SMDs mounted to the upper surface of substrate **130.**

Microelectronic devices **180** are at least partially nested or positioned between bondwire arrays **120, 122.** Stated differently, bondwire arrays **120, 122** extend over devices **180** in a bridge-like fashion. Alternatively, some or all of the bondwires in bondwire arrays **120, 122** may physically and electrically contact top surfaces of microelectronic devices **180** along the length of the bondwires to provide electrical connectivity to microelectronic devices **180** (particularly when the below-described wings **188** are not included in assembly **176**). Such arrangements achieve highly dense circuit structures, but again presents an opportunity for undesired EM cross-coupling between devices **180** and bondwire arrays **120, 122** if adequate countermeasures are not provided. Thus, in the example of FIG. 11, EM shield structure **178** is produced to further include two lateral extensions or shield wings **188,** which extend in directions opposing principal surfaces of main body **182** of EM shield structure **178** over microelectronic devices **180.** Shield wings **188** thus at least partially cover or shroud devices **180,** as viewed along an axis orthogonal to the upper surface of substrate **130.** Shield wings **188** may or may not be directly bonded to microelectronic devices **180;** and, along with main body **182** of EM shield structure **178,** wings **188** may be formed of a magnetically-permeable material of a type previously described to reduce magnetic cross-coupling between devices **180** and bondwire arrays **120, 122** during operation of EM-shielded microelectronic assembly **176.** In still further embodiments, wings **188** may be replaced by discrete sheets or blocks of material, which are joined (e.g., utilizing epoxy or a die attach material) to the upper surfaces of microelectronic devices **180.** As a still further possibility, shield wings **188** may be replaced by deposited layers of a magnetically-permeable material (e.g., a sputter-deposited Mu metal or permalloy) applied directly to the upper surfaces of devices **180** in alternative implementations of EM-shielded microelectronic assembly **176.**

Finally, if desired, EM shield structure **178** may be produced to include one or more electrical shield layers **190,** which may contact and/or be bonded to one or more magnetic shield layers **191** further included in shield structure **178.** For example, as indicated in FIG. 11, an electrical shield layer **190** may be provided as a continuous (non-patterned) layer or body disposed between two magnetic shield layers **191,** which face opposing wirebond arrays **124.** To this end, in certain implementations, electrical shield layer **190** may be a core layer to which magnetic shield layers **191** are joined as mirror opposites utilizing, for example, an epoxy or other bonding material. As previously indicated, electric shield layer **190** may be composed of a material having a magnetic permeability less than and an electrical conductivity greater than the magnetic permeability and electrical conductivity, respectively, of portions of EM shield structure **178** produced from a magnetically-permeable material (namely, shield layers **191**). Further, in at least some implementations, electrical shield layer **190** may be composed of a material having an electrical conductivity at least 50% greater, if not at least twice the electrical conductivity of the material from which magnetic shield layers **191** are composed; while magnetic shield layers **191** may be composed of a material having a magnetic permeability at least 50% greater, if not at least twice the magnetic permeability of the material from which electrical shield layer **190** is composed. When provided, electrical shield layer **190** may be electrically grounded or may be left electrically floating. In alternative implementations, EM shield structure **178** may lack such an electrically-conductive core layer; or be produced to include additional regions or portions formed from an electrically-conductive material, as appropriate to suit a particular application or usage.

### ADDITIONAL EXAMPLES OF MICROELECTRONIC MODULES AND SYSTEMS CONTAINING EM SHIELD STRUCTURES

While principally described above in conjunction with exemplary microelectronic packages, such as microelectronic package **62** shown in FIG. 3, it is emphasized that embodiments of the EM shield structures described herein are not so limited. Instead, embodiments of the EM shield structures can be integrated into various different types of microelectronic assemblies prone to EM cross-coupling including, but not limited to, microelectronic modules and systems. As a more specific example, embodiments of the presently-disclosed EM shield structures may be beneficially integrated into modules and systems containing RF circuitry and/or possessing relatively compact form factors to, for example, reduce EM cross-coupling between closely-spaced active devices. To further underscore the versatility of the above-described EM shield structures, a microelectronic assembly **200** in the form of an exemplary massive MIMO transceiver module is further presented in FIG. 12, as seen from a top-down or planform perspective. In this example, microelectronic assembly **200** includes two EM wall-like shield structures **202, 204,** which are bonded to an assembly substrate **206** at locations strategically chosen to reduce EM cross-coupling between devices, networks, or modules carrying different electrical signals. In addition to EM shield structures **202, 204** and assembly substrate **206,** microelectronic assembly **200** further includes a number of terminals **208** (e.g., female co-axial connectors), an RF PA packaged device **210,** and a number of other microelectronic package devices **212,** which are electrically interconnected along with other various devices (e.g., SMDs). Package devices **210, 212** are included in transmitter path circuitry (generally outlined by box **214** in FIG. 12) and in receiver path circuitry (outlined by box **216)** of assembly **200.**

EM shield structures can be provided at any number of locations within assembly **200**; e.g., one or more EM shield structures may be usefully integrated into RF PA packaged device **210** between different RF sub-networks; e.g., between peaking and carrier amplification paths when device **210** includes a Doherty PA. An EM shield structure **202** can also be provided between receiver path circuitry **214** and transmitter path circuitry **216,** as shown in FIG. 12. Shielding can also be provided between analog (RF) and digital networks contained in assembly **200** and/or may further be provided around the outer periphery of circuitry of assembly **200,** generally. In this regard, EM shield structure **204** may include an outer peripheral wall or cage portion **218,** which extends around the periphery of core circuit elements contained in assembly **200.** Peripheral wall **218** may form a closed polygon shape (e.g., a rectangular shape) as viewed from a top-down or planform perspective; that is, along the Z-axis identified by coordinate legend **222.** Additionally, EM shield structure **204** may include a dividing wall or internal partition **220,** which physically separates portions of the receiver and transmitter networks included in assembly **200.** Shield structures **202, 204** can be imparted with any of the constructions described above in conjunction with FIGs. 2-4, 6, 7, and 11, or variations thereof. Accordingly, EM shield structures **202, 204** may each be produced to include an electrical shielding portion or layer bonded to (or otherwise brought in contact or close proximity with) a magnetic shield portion or layer, as previously described and as indicated in FIG. 12 by dot stippling. EM shield structures **202, 204** are usefully imparted with an average or peak height (as measured along the Z-axis of legend **222**) equal to or greater than the heights of one or all of packages **210, 112;** although the respective heights (and other dimensions) of shield structures **202, 204** may vary in other embodiments. In this manner, the provision of EM shield structures **202, 204** may consequently decrease, if not eliminate EM cross-coupling during operation of assembly **200** to provide the above-described enhancements to assembly performance.

### CONCLUSION

There has thus been provided examples of EM-shield microelectronic assemblies, which reduce EM cross-coupling between different signal paths contained in the microelectronic assemblies to enhance performance, even the assembly is operated at higher (e.g., RF) frequencies and/or relatively high power levels and is imparted with a relatively compact form factor. While principally described above in the context of high frequency RF applications, the EM-shielded microelectronic assemblies can be utilized in various different applications in which EM cross-coupling between different signal lines is commonly problematic, whether the signal paths carry digital signals (e.g., as in the case of clock lines), analog signals, or a combination thereof. As further described above, the EM-shielded microelectronic assemblies can be integrated into various different types of microelectronic packages, modules, and assemblies without limitation. As compared to microelectronic assemblies incorporating conventional electrical shield structures, the above-described EM shield structures can achieve significant improvements in isolation rates, which may approach or exceed 20 dB in at least some instances. Embodiments of the present disclosure are consequently well-suited for integration into highly linear and efficient (e.g., LDMOS, GaN, or other) RF power amplifiers. Additionally, embodiments of the disclosure are well-suited for usage in integrated products, such as RF amplifier and/or transceiver modules, due to proximity of active devices in such products. It still further embodiments, the EM-shielded microelectronic assemblies can be incorporated into various other types of microelectronic devices in which enhanced EM shielding is desired.

## Claims

1. An electromagnetically-shielded microelectronic assembly (144), comprising:
first (123) and second (125) signal paths, which carry different electrical signals during operation of the microelectronic assembly; and
an electromagnetic, EM, shield structure (146) positioned between the first (123) and second (125) signal paths, the EM shield structure comprising:
a magnetic shield portion having a first magnetic permeability and a first electrical conductivity;
an electrical shield portion adjacent the magnetic shield portion, the electrical shield portion having a second magnetic permeability less than the first magnetic permeability and having a second electrical conductivity greater than the first electrical conductivity;
the electromagnetically-shielded microelectronic assembly further comprising an assembly substrate (130) having a frontside from which the EM shield structure projects, a first interconnect feature (124) through which the first signal path extends, bonded to the substrate, and located on a first side of the EM shield structure and a second interconnect feature (132) through which the second signal path extends, bonded to the substrate, and located on a second, opposing side of the EM shield structure;
wherein the EM shield structure (146) further comprises a dielectric substrate layer (148) having a first principal surface and a second principal surface opposite the first principal surface; and wherein the magnetic shield portion comprises a magnetic shield layer (152) in contact with the first principal surface, the electrical shield portion comprises an electrical shield layer (154) in contact with the second principal surface of the dielectric substrate layer;
and wherein the first interconnect feature (124) comprises a bondwire bent into a curved shape, and wherein at least one of the magnetic shield layer and the electrical shield layer is patterned to have a planform geometry corresponding to the curved shape of the bondwire.

## Patentansprüche

1. Elektromagnetisch abgeschirmte Mikroelektronikbaugruppe (144), umfassend:
einen ersten (123) und zweiten (125) Signalpfad, die während des Betriebs der Mikroelektronikbaugruppe unterschiedliche elektrische Signale führen; und
eine elektromagnetische, EM-, Abschirmstruktur (146), die zwischen dem ersten (123) und dem zweiten (125) Signalpfad positioniert ist, wobei die EM-Abschirmstruktur umfasst:
einen magnetischen Abschirmabschnitt mit einer ersten magnetischen Permeabilität und einer ersten elektrischen Leitfähigkeit;
einen elektrischen Abschirmabschnitt bei dem magnetischen Abschirmabschnitt, wobei der elektrische Abschirmabschnitt eine zweite magnetische Permeabilität kleiner als die erste magnetische Permeabilität und eine zweite elektrische Leitfähigkeit größer als die erste elektrische Leitfähigkeit aufweist;
wobei die elektromagnetisch abgeschirmte Mikroelektronikbaugruppe weiter ein Baugruppensubstrat (130) mit einer Vorderseite, von der die EM-Abschirmstruktur vorsteht, ein erstes Zwischenverbindungsmerkmal (124), durch das sich der erste Signalpfad erstreckt, an das Substrat gebondet, und angeordnet auf einer ersten Seite der EM-Abschirmstruktur, und ein zweites Zwischenverbindungsmerkmal (132), durch das sich der zweite Signalpfad erstreckt, gebondet an das Substrat und angeordnet auf einer zweiten gegenüberliegenden Seite der EM-Abschirmstruktur, aufweist;
wobei die EM-Abschirmstruktur (146) weiter eine dielektrische Substratschicht (148) mit einer ersten Hauptoberfläche und einer zweiten Hauptoberfläche gegenüber der ersten Hauptoberfläche umfasst; und wobei der magnetische Abschirmabschnitt eine magnetische Abschirmschicht (152) in Kontakt mit der ersten Hauptoberfläche umfasst, wobei der elektrische Abschirmabschnitt eine elektrische Abschirmschicht (154) in Kontakt mit der zweiten Hauptoberfläche der dielektrischen Substratschicht umfasst; und wobei das erste Zwischenverbindungsmerkmal (124) einen in einer gekrümmten Form gebogenen Bonddraht umfasst und wobei mindestens eine der magnetischen Abschirmschicht und der elektrischen Abschirmschicht so strukturiert ist, dass sie eine planforme Geometrie entsprechend der gekrümmten Form des Bonddrahts aufweist.

## Revendications

1. Ensemble microélectronique à écran électromagnétique (144), comprenant :
des premier (123) et second (125) chemins de signaux, qui transportent différents signaux électriques durant le fonctionnement de l'ensemble microélectronique ; et
une structure d'écran électromagnétique, EM, (146) positionnée entre les premier (123) et second (125) chemins de signaux, la structure d'écran EM comprenant :
une partie écran magnétique ayant une première perméabilité magnétique et une première conductivité électrique ;
une partie écran électrique adjacente à la partie écran magnétique, la partie écran électrique ayant une seconde perméabilité magnétique inférieure à la première perméabilité magnétique et ayant une seconde conductivité électrique supérieure à la première conductivité électrique ;
l'ensemble microélectronique à écran électromagnétique comprenant en outre un substrat d'ensemble (130) ayant un côté avant à partir duquel la structure d'écran EM fait saillie, un premier dispositif d'interconnexion (124) à travers lequel le premier chemin de signaux s'étend, connecté au substrat, et situé sur un premier côté de la structure d'écran EM et un second dispositif d'interconnexion (132) à travers lequel le second chemin de signaux s'étend, connecté au substrat, et situé sur un second côté opposé de la structure d'écran EM ;
dans lequel la structure d'écran EM (146) comprend en outre une couche de substrat diélectrique (148) ayant une première surface principale et une seconde surface principale opposée à la première surface principale ; et dans lequel la partie écran magnétique comprend une couche écran magnétique (152) en contact avec la première surface principale, la partie écran électrique comprend une couche écran électrique (154) en contact avec la seconde surface principale de la couche de substrat diélectrique ; et dans lequel le premier dispositif d'interconnexion (124) comprend un fil de connexion courbé en une forme courbe, et dans lequel au moins une de la couche écran magnétique et de la couche écran électrique est façonnée pour avoir une géométrie de forme plane correspondant à la forme courbée du fil de connexion.
